# EUROPEAN PATENT APPLICATION

(11) **EP 4 037 187 A1**
(43) Date of publication of application: **03.08.2022**
(21) Application number: 21154416.8
(22) Date of filing: 29.01.2021
(51) Int. Cl.: H03K 17/12, H03K 17/16, H02M 1/088

(54) **SEMICONDUCTOR UNIT WITH ASYMMETRICALLY ARRANGED COMMON MODE CHOKES ON GATE DRIVER INPUT SIDE**

(71) Applicant: ABB Schweiz AG, 5400 Baden (CH)
(72) Inventor: Burkart, Ralph Mario, 8037 Zürich (CH); Kieferndorf, Frederick, 5400 Baden (CH); Park, Ki-Bum, 5442 Fislisbach (CH); Grecki, Filip, 5406 Rütihof (CH); Bahmani, Amin, 5018 Erlinsbach (CH); Abrach, Stefan, 8005 Zürich (CH); Luescher, Matthias, 5728 Gontenschwil (CH)
(74) Representative: Qip Patentanwälte Dr. Kuehn & Partner mbB

(57) **Abstract**

A semiconductor unit (10) comprises a first semiconductor switch (16a) and a second semiconductor switch (16b), which are connected in parallel and a gate driver circuit (14); wherein the gate driver circuit (14) comprises a first gate driver (26a) for the first semiconductor switch (16a) and a second gate driver (26b') for the second semiconductor switch (16b); wherein each gate driver (26a, 26b') comprises an amplifier (30) with a positive supply voltage input (34), a negative supply voltage input (36) and a gate signal input (38) for receiving a gate signal and for connecting a gate of the respective semiconductor switch (16a, 16b) via a gate output (52) with one of the positive supply voltage input (34) and the negative supply voltage input (36); wherein the first gate driver (26a) comprises a common mode choke (28) for coupling at least two inputs (34, 36, 38) of the positive supply voltage input (34), the negative supply voltage input (36) and the gate signal input (38) of the first gate driver (26a) via an impedance for a common mode current through the at least two inputs (34, 36, 38); and wherein the at least two inputs (34, 36, 38, 50) of the second gate driver (26b') are coupled with a lesser common mode impedance.

## Description

### FIELD OF THE INVENTION

The invention relates to a semiconductor unit with at least two semiconductor switches.

### BACKGROUND OF THE INVENTION

Hard-paralleling of semiconductor switches is a widely adopted strategy to increase the power rating of a switched-mode power electronic converter. Hard-paralleling may be achieved by short-circuiting the individual semiconductor switches at their power terminals. One challenge of hard-paralleling lies in balancing of the individual module currents during the on-state (static balancing) and during the switching transients (dynamic balancing). A current imbalance may lead to a non-equal power loss distribution and higher temperatures in the semiconductor switches with higher currents. In order not to exceed the maximum junction temperature in any of the semiconductor switches, derating of the total current capability may become necessary, which may result in higher costs, when compared to balanced operation.

For operating hard-paralleled semiconductor, a suitable gate driver is needed. Active gate driver concepts sense the currents and voltages in the paralleled semiconductor in order to adjust the individual gate voltages such that balanced conditions are achieved. Passive gate driver concepts apply a fixed gate voltage waveform that does not rely on feedback. Passive gate driver concepts are usually preferred due to their simplicity and low cost.

As an example for a passive gate driver concept, WO 2019/012038 A1 shows two semiconductor switches in parallel with two common mode chokes, each of which is arranged on the input side of an amplifier for providing the gate signal to a respective semiconductor switch.

There may be stringent requirements for the parasitic leakage inductance of the CM chokes. High values of the inductance may lead to undesired oscillations in the gate path whereas unequal values due to tolerances may introduce asymmetries between the gate voltage waveforms. Furthermore, common mode chokes are subject to pulsed currents with high average values. All these factors impose restrictions and thus complicate the design of gate drivers with common mode chokes. These difficulties can largely be overcome by employing distributed rather than a single central amplifier and by moving the common mode chokes from the output side to the distributed amplifiers.

### DESCRIPTION OF THE INVENTION

When hard-paralleling two or more half bridges, in a passive gate driver concept with common mode chokes, additional current loops in the power supplies of the gate drivers may be generated. These current loops have to be considered, when designing the gate driver circuit.

It is an objective of the invention to provide a simple and effective solution to equalize and reduce the switching losses of paralleled semiconductor switches.

This objective is achieved by the subject-matter of the independent claim. Further exemplary embodiments are evident from the dependent claims and the following description.

The invention relates to a semiconductor unit, which comprises a first semiconductor switch and a second semiconductor switch, which are connected in parallel. It is possible that the semiconductor unit comprises more than two semiconductor switches, which are connected in parallel. A semiconductor switch may be a thyristor or transistor such as an IGBT, MOSFET, etc.

The semiconductor unit may be a power semiconductor unit and/or the semiconductor switches may be power semiconductor switches. It has to be noted that the term "power" may refer to devices adapted for processing voltages of more than 100 V and/or 10 A. For example, a voltage rating for a power semiconductor switch used in a power semiconductor unit may range between 600 V and 10 kV.

The semiconductor unit furthermore comprises a gate driver circuit, wherein the gate driver circuit comprises a first gate driver for the first semiconductor switch and a second gate driver for the second semiconductor switch. Each gate driver may comprise an amplifier with a positive supply voltage input, a negative supply voltage input and a gate signal input for receiving a gate signal and for connecting a gate of the respective semiconductor switch via a gate output with one of the positive supply voltage input and the negative supply voltage input. Each gate driver furthermore may comprise a reference potential input connected with a reference potential output, which is connected to a negative input of the respective semiconductor switch.

The gate driver circuit furthermore may comprise a power supply for supplying the gate drivers via the positive supply voltage input and the negative supply voltage input.

The positive supply voltage input and the negative supply voltage input of each gate driver may be supplied with a constant voltage of for example +15 V and -15 V. The gate signal, which may be an on-and-off-signal, may be provided by a controller of the semiconductor unit. This controller also may be connected with a reference potential input provided by the gate driver circuit. The reference potential input may be connected with the negative outputs of the semiconductor switches and/or may be seen as a part of the respective gate driver. The reference potential input potential may have a voltage of 0 V per definition. The positive supply voltage input, the negative supply voltage input, the gate signal input and the reference potential input may be seen as auxiliary inputs of the gate driver.

The first gate driver comprises a common mode choke for coupling at least two of the first gate driver via an impedance for a common mode current through the at least two inputs of the first gate driver. At least two inputs of the positive supply voltage input, the negative supply voltage input the reference potential input and the gate signal input may be coupled via the common mode choke.

Contrary to this, the at least two inputs of the second gate driver are coupled with a common mode impedance, which may be substantially lesser than the common mode impedance of the at least two input of the first gate driver. The at least two inputs of the second gate driver may be coupled with a common mode impedance that is less than 10% or even less than 1% of the common mode impedance of the at least two inputs of the first gate driver. This may be achieved with no common mode choke or no active common mode choke, which is connected into the at least two inputs of the second gate driver. The at least two inputs may be directly connected to the power supply. The at least two inputs of the second gate driver may be the same inputs as the at least two inputs of the first gate driver.

One or more common mode chokes may be asymmetrically arranged in the gate driver circuit. One or more common mode chokes may be solely interconnected into the inputs of the first gate driver. This reduces parasitic current loops in the power supply of the gate driver circuit and improves the switching behavior of the semiconductor unit.

A coupling with no common mode or a substantially lesser common mode impedance may be achieved with a direct electrical connection without any inductor between the respective input and the power supply. The power supply itself may comprise an inductance, such as the leakage inductance of an isolation transformer.

In general, the current through the auxiliary inputs of each gate driver may be seen as a multi-pole current. A common mode current may be seen as the average of the sum of the pole currents, i.e. the current through the auxiliary inputs. This common mode current may be limited and/or reduced by the common mode choke. The impedance of the common mode choke may be an impedance for damping a time derivative of the common mode current. Thus, the impedance may damp the common mode voltage of the common mode current.

It has to be noted that also common mode chokes may be present for the second gate driver. However, these common mode chokes may be bypassed and/or connected to the inputs of the respective gate driver, such that no common mode impedance is present.

As already mentioned, the semiconductor unit may comprise more than two semiconductor switches connected in parallel. In this case, for at least one of the semiconductor switches, no or nearly no common mode coupling is provided in between the inputs and optionally no or nearly no common mode coupling may be provided for the outputs. For the remaining semiconductor switches, each of the first gate drivers comprises a common mode choke for coupling at least two inputs, such as at least the positive supply voltage input and the negative supply voltage input via an impedance for a common mode current through at least the positive supply voltage input and the negative supply voltage input.

When the semiconductor unit comprises more than two semiconductor switches connected in parallel, it may be that solely one of the semiconductor switches in a parallel connection is configured without and/or with bypassed common mode chokes. All other semiconductor switches may be configured with an active common mode choke, such as described above.

According to an embodiment of the invention, the common mode choke for the first gate driver couples at least the positive supply voltage input and the negative supply voltage input via an impedance for a common mode current through at least the positive supply voltage input and the negative supply voltage input.

It may be that not only the positive supply voltage input and the negative supply voltage inputs of the first gate driver are coupled by the common mode choke. Also the gate signal input and/or the reference potential input may be coupled with these inputs and with each other.

According to an embodiment of the invention, both the positive supply voltage input and the negative supply voltage input of the second gate driver may be no or nearly no common mode coupled and/or may be directly connected to the power supply. It may be that both supply voltage inputs are directly connected to a respective isolation transformer.

According to an embodiment of the invention, the common mode choke for the first gate driver couples at least the positive supply voltage input the negative supply voltage input and the gate signal input via an impedance for a common mode current through at least the positive supply voltage input the negative supply voltage input and the gate signal input.

According to an embodiment of the invention, the common mode choke for the first gate driver couples at least the positive supply voltage input, the negative supply voltage input and the reference potential input via an impedance for a common mode current through at least the positive supply voltage input the negative supply voltage input and the reference potential input.

According to an embodiment of the invention, the common mode choke comprises a single core with windings interconnected into the at least two inputs. For the first gate driver, a first winding on the core may be interconnected in the positive supply voltage input; and a second winding on the core may be interconnected in the negative supply voltage input. There also may be windings for the gate signal input and/or the reference potential input, which also may be provided on the single core.

According to an embodiment of the invention, the second gate driver comprises a common mode choke interconnected in inputs of the second gate driver. The common mode choke is at least partially bypassed, for example for directly connecting at least some of the inputs with the power.

According to an embodiment of the invention, at least one winding of the common mode choke of the second gate driver is bypassed and/or short-circuited. It may be that one or all inputs have bypassed windings.

According to an embodiment of the invention, two windings of the common mode choke of the second gate driver are series connected and are interconnected into one of the inputs. Also in this way, a common mode impedance is avoided. The series connection of the two windings of the second common mode choke may equalize stray inductances for the semiconductor switches, which may effects the differential mode behavior of the switches.

According to an embodiment of the invention, the power supply comprises an isolation transformer supplying the positive supply voltage input and the negative supply voltage input of the first gate driver and the second gate driver. The power supply may comprise one or more isolation transformers, which supply the gate drivers with power and which are supplied by a power source.

According to an embodiment of the invention, the isolation transformer is connected via an amplifier with a power source.

According to an embodiment of the invention, the semiconductor unit comprise a first half bridge and a second half bridge, wherein the first half bridge comprising a first high side semiconductor switch and a first low side semiconductor switch, which are connected in series, wherein the second half bridge comprises a second high side semiconductor switch and a second low side semiconductor switch, which are connected in series. The high side semiconductor switches are connected in parallel and the low side semiconductor switches are connected in parallel.

The paralleled high side switches and/or the paralleled low side switches may be provided with gate drivers and common mode chokes are described above.

Each of the first and the second half bridge may be provided by a semiconductor module. Also both half bridges may be provided by a semiconductor module. A semiconductor module may be any device that mechanically and electrically interconnects two or more semiconductor switches and their electrical interconnections. Usually, a semiconductor module comprises a housing for accommodating the two or more semiconductor switches and/or their electrical interconnections, which housing also may provide inputs for electrical interconnecting the power semiconductor unit with other power semiconductor units and/or, for example, the circuitry of an electrical converter.

The first half bridge and the second half bridge may be hard-paralleled, for example via their power terminals, which may be provided by the housing. It is possible that more than two half bridges are hard-paralleled.

According to an embodiment of the invention, the gate driver circuit comprises first gate drivers for the first semiconductor switches of the first half bridge and second gate drivers for the second semiconductor switches of the second half bridge. Each of the first gate drivers may comprise a common mode choke for coupling at least two inputs of the respective first gate driver via an impedance for a common mode current through the at least two inputs of the respective first gate driver. The inputs of the second gate drivers are not or nearly not common mode coupled.

Each of the first gate drivers may comprise a common mode choke for coupling inputs of the first gate driver, such as the positive supply voltage input and the negative supply voltage input, via a large impedance for common mode current through these inputs. Furthermore, the second gate drivers do not have active common mode chokes in their inputs. It also may be that all gate drivers do not have common mode chokes in their outputs.

According to an embodiment of the invention, the power supply comprises a high side isolation transformer supplying the positive supply voltage input and the negative supply voltage input of the first high side gate driver and of the second high side gate driver connected to the high side semiconductor switches of the first half bridge and the second half bridge.

Accordingly, the power supply comprises a low side isolation transformer supplying the positive supply voltage input and the negative supply voltage input of the first low side gate driver and of the second low side gate driver connected to the low side semiconductor switches of the first half bridge and the second half bridge.

According to an embodiment of the invention, the high side isolation transformer and the low side isolation transformer are connected via an amplifier with a power source.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a semiconductor unit with symmetrically arranged common mode chokes.
Fig. 2 schematically shows a semiconductor unit with asymmetrically arranged common mode chokes according to an embodiment of the invention.
Fig. 3 schematically shows a semiconductor unit according to an embodiment of the invention.
Fig. 4A to 4E schematically show embodiments of bypassed common mode chokes according to embodiments of the invention.
Fig. 5 shows diagrams with voltages and fluxes in the semiconductor unit of Fig. 1.
Fig. 6 shows diagrams with voltages and fluxes in the semiconductor unit of Fig. 2.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

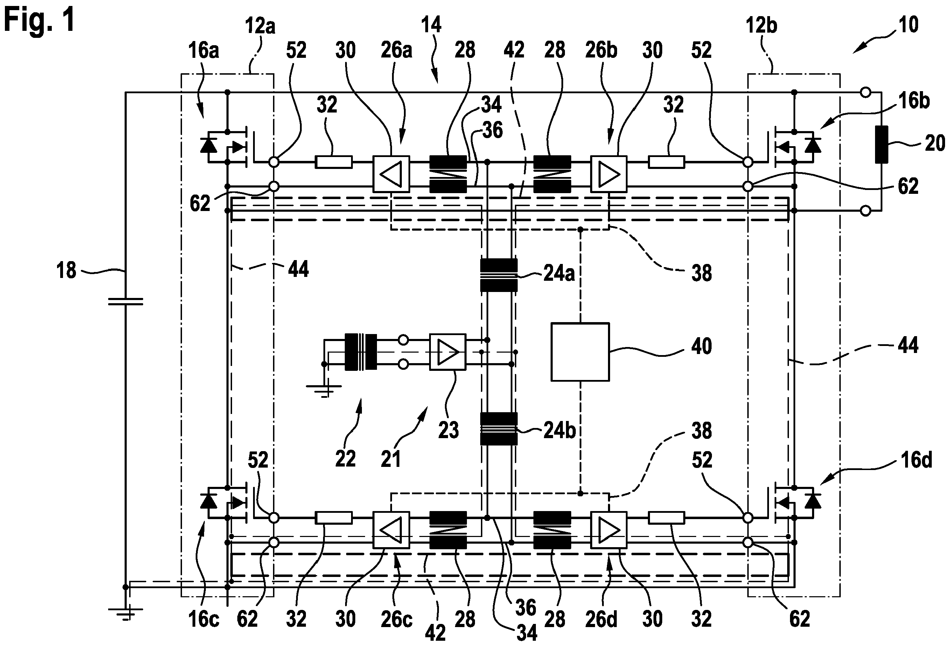

Fig. 1 shows a semiconductor unit 10 comprising two half bridges 12a, 12b and a gate driver circuit 14.

Each of the half bridges 12a, 12b comprises two semiconductor switches 16a, 16c (or 16b, 16d), which are series connected. Each the half bridges 12a, 12b may be provided by a semiconductor module. The semiconductor switches 16a, 16b, 16c, 16d may be MOSFETs, IGBTs or thyristors. As shown, a semiconductor switch 16a, 16b, 16c, 16d may comprise a switching device and an antiparallel freewheeling diode.

The half bridges 12a, 12b are connected in parallel, i.e. the ends and the midpoints of the two high side semiconductor switches 16a, 16b are connected with each other. The same applies to the low side semiconductor switches 16c, 16d. The half bridges 12a, 12b are connected to a DC voltage source 18 (here a capacitive DC link) via the endpoints and an AC load 20, for example via the midpoint and one endpoint.

The gate driver circuit 14 comprises a power supply 21 with power source 22 and an amplifier 23 connected thereto, which supplies the primary sides of two isolating transformers 24a, 24b. The primary sides of the isolating transformers 24a, 24b are connected in parallel.

The gate driver circuit 14 further comprises four gate drivers 26a, 26b, 26c, 26d. Each gate driver comprises a common mode choke 28, an amplifier 30 and a gate resistance 32. Other elements such as gate driver rectifiers, additional converters, capacitors, protective elements, etc. may also be integrated in each gate driver 26a, 26b, 26c, 26d but are omitted in this description.

The amplifier 30 has a positive supply voltage input 34, a negative supply voltage input 36 and a gate signal input 38. At its output side, the amplifier 30 is connected via the gate resistance 32 with the gate of the respective semiconductor switch 16a, 16b, 16c, 16d and is connected to a negative output of the semiconductor switch 16a, 16b, 16c, 16d. A gate signal can be provided to the gate signal input 38 of the amplifier 30, which then may connect the gate either to the positive supply voltage input 34, a negative supply voltage input 36.

The gate signal is provided by a controller 40, which generates a gate signal for the high side gate drivers 26a, 26b and a further gate signal for the low side gate drivers 26c, 26d.

The positive supply voltage input 34 and the negative supply voltage input 36 of the high side gate drivers 26a, 26b are connected to the secondary winding of the high side isolation transformer 24a. The positive supply voltage input 34 and the negative supply voltage input 36 of the low side gate drivers 26c, 26d are connected to the secondary winding of the low side isolation transformer 24b.

Each common mode choke 28 is interconnected in the positive supply voltage input 34 and the negative supply voltage input 36 of the respective gate driver 26a, 26b, 26c 26d. Each common mode choke is adapted for coupling the positive supply voltage input 34 and the negative supply voltage input 36 via an impedance for a common mode current through the positive supply voltage input 34 and the negative supply voltage input 36.

Fig. 1 furthermore shows circulating current loops 42, 44 of the gate driver circuit 14. The placement of the common mode chokes 28 allows to suppress circulating currents in the loops 42 defined by the emitter paths between the half bridges 12a, 12b. The voltages in the loops 42 that are ideally taken by the common mode chokes 28 may be for example a result of unequal bus bar stray inductances, which are interconnecting the terminals of the half bridges 12a, 12b.

However, in addition to the loops 42, unintended parasitic loops 44 are present between a high-side and a low-side of the half bridges 12a, 12b. The parasitic loops 44 are driven by the high-side/low-side voltage commutations of the semiconductor switches 16a, 16b, 16c, 16d, which involves a charging and discharging of the non-negligible stray capacitances of the auxiliary isolation transformers 24a, 24b. Corresponding unintended parasitic loops 44 would be present, when solely the high side or low side part of the circuit would be present.

An additional high-side/low-side path also exists through ground which may involve a supply transformer of the power source 22.

At typical frequency ranges of the voltage transients, the impedance of the common mode chokes 28 is usually non-negligible, when compared to the equivalent impedance of the involved parasitic stray capacitances of the isolation transformers 24a, 24b. A considerable share of the transient voltage may apply across the common mode chokes 28 instead of being taken by the isolation transformers 24a, 24b.

The high-side/low-side loops 44 may result in a more complex magnetic design of the common mode chokes 28, since a saturation of the common mode chokes 28 should be avoided. Furthermore, an upper limit of the common mode choke inductances may be strongly constrained. Increased losses may be caused due to the increased voltage and current load on the common mode chokes. Additionally, a peak voltage/insulation and peak flux requirements may increase with the switching speed and are thus more challenging to fulfil with fast semiconductors, such as SiC switches.

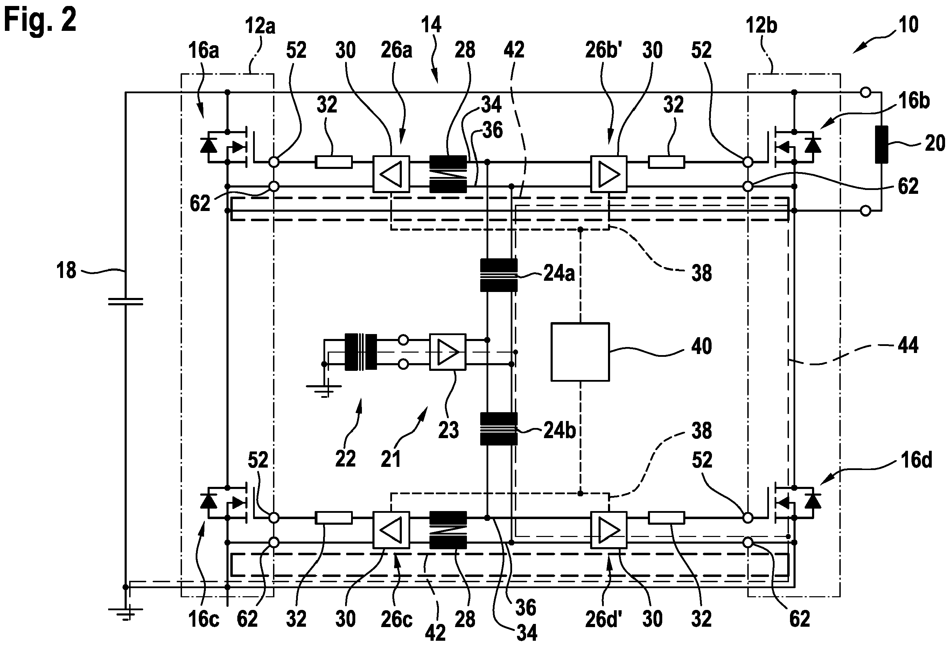

In Fig. 2, a semiconductor unit 10 with a gate driver circuit 14 having asymmetrically arranged common mode chokes 28 is shown. For the first half bridge 12a, common mode chokes 28 as in Fig. 1 are present. Each of the first gate drivers 26a, 26c comprises a common mode choke 28 for coupling at least the positive supply voltage input 34 and the negative supply voltage input 36 via an impedance for a common mode current through at least the positive supply voltage input 34 and the negative supply voltage input 36. For the second half bridge 12b, different common mode chokes 28 (such as in Fig. 1) with substantially lower common mode impedance (such as less than 10% of the common mode impedance of the common mode choke 28), no common mode chokes (such as shown in Fig. 2) or bypassed common mode chokes 28' (see below) are present. The positive supply voltage input 34 and the negative supply voltage input 36 of each of the amplifiers 30 of the second gate drivers 26b', 26d' are not or nearly not common mode coupled with each other and/or are directly connected to the power supply 21. Here, a direct connection is achieved by connecting the inputs 34, 36 of the amplifiers 30 of the second gate driver 26b', 26d' directly to the isolating transformers 24a 24b, i.e. without any impedance between them.

In general, the semiconductor unit 10 may comprise more than two half bridges 12a, 12b. In this case, for at least one of the half bridges 12b, the positive supply voltage input 34 and the negative supply voltage input 36 of each second gate driver 26b', 26d' may be are not common mode coupled with each other and/or directly connected to the power supply 21. For the remaining half bridges 12a, the first gate drivers 26a, 26c comprise a common mode choke 28 for coupling the positive supply voltage input 34 and the negative supply voltage input 36 via an impedance for a common mode current through at least the positive supply voltage input 34 and the negative supply voltage input 36.

When the semiconductor unit 10 comprises more than two half bridges 12a, 12b (say N), it may be that solely one of the half bridges 12b is configured with different, bypassed and/or missing common mode chokes 28'. The other N-1 half bridges 12a may be configured with an active common mode choke 28.

One common mode choke 28 on the high side and/or the low side of one half bridge 12b may be short-circuited and/or bypassed, i.e. the implementation of *N*-1 common mode chokes 28 only, where N denotes the number of hard-paralleled half bridges 12a, 12b.

As shown in Fig. 2, the missing and/or not active common choke in one of the parallel gate driver paths creates a current loop 44 with low impedance which allows to charge/discharge the parasitic capacitances of the isolation transformers 24a, 24b in a largely unconstrained manner. In such a way, transient voltage caused by the semiconductor switches 16a, 16b, 16c, 16d may be fully taken by the dedicated isolation transformer 24a, 24b instead of partly by the common mode chokes 28, which usually are not designed for this purpose. Such a current loop 44 with low impedance also would be present, when solely the high side or the low side part of the circuit would be present.

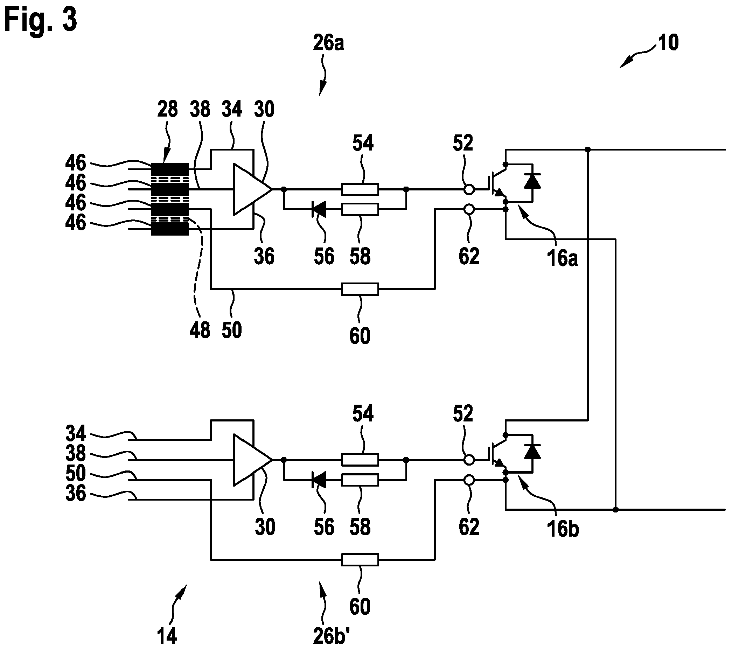

Fig. 3 shows an embodiment of a first gate driver 26a, with a common mode choke 28 which comprises four windings 46, which are coupled via a common core 48. The gate driver 26a, 26c has four inputs, the positive supply voltage input 34, the negative supply voltage input 36, the gate signal input 38 and a reference potential input 50.

The common mode choke 28 couples the positive supply voltage input 34, the negative supply voltage input 36, the gate signal input 38 and the reference potential input 50 via an impedance for a common mode current through these inputs. For each of the inputs, a winding 46 of the common mode choke 28 is interconnected into the respective input 34, 36, 38, 50. The common mode choke 28 is interconnected into inputs 34, 36, 38, 50 of the gate driver 26a.

The amplifier 30 is adapted for connecting the gate output 52 and the gate of the semiconductor switch 16a with the positive supply voltage input 34 and the negative supply voltage input 36 based on the gate signal provided via the gate signal input 38. For example, when the gate signal is positive, then the amplifier 30 connects the gate output 52 to the positive supply voltage input 34 and when the gate signal is negative, then the amplifier 30 connects the gate output 52 to the negative supply voltage input 36.

The output of the amplifier 30 may be connected via a gate resistance 32 with the gate output 52 connected to the gate of the semiconductor switch 16a. The gate resistance 32 may comprise a gate resistor 54 connected in parallel with a series connection of diode 56 and a further gate resistor 58. This makes it possible to provide a gate resistance 32 that depends on the positive and negative side of the voltage supplied to the gate output 52.

The reference potential input 50 may be connected via a resistor 60 with a reference potential output 62, which is connected to the negative input and/or emitter of the semiconductor switch 16a.

The second gate drivers 26b' is designed in the same way, except that the common mode choke 28 is not present, is not active and/or is bypassed.

The gate drivers 26c and 26d' of Fig. 2 may be designed in the same way as shown in Fig. 3.

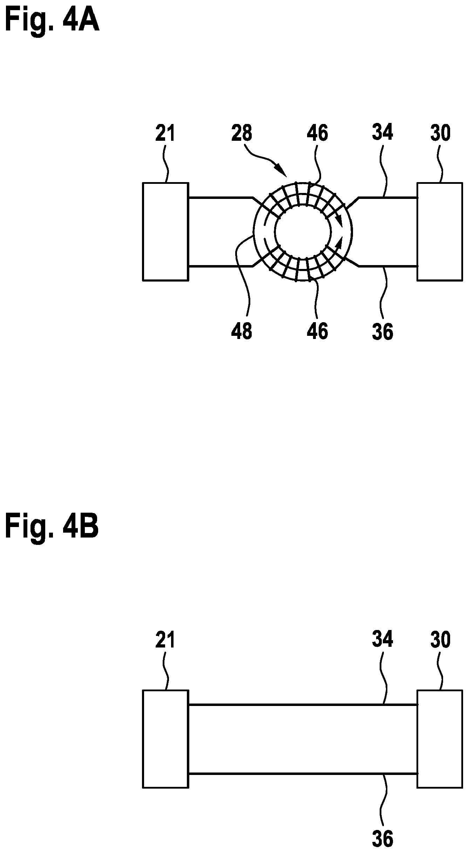

Fig. 4A shows a further embodiment of a common mode choke 28 solely for the positive supply voltage input 34 and the negative supply voltage input 36, which may be used for first gate drivers 26a, 26c. The common single core 48 comprises two windings 46 for each of the positive supply voltage input 34 and the negative supply voltage input 36. The other two inputs 38, 50 may by directly connected to the controller 40, i.e. without an impedance provided by a common mode choke.

Fig. 4B schematically shows that both the supply voltage input 34 and the negative supply voltage input 36 are directly connected to the power supply 21, which connection may be used for second gate drivers 26b', 26d'. There is no impedance provided by a common mode choke between the amplifier 30 and the power supply 21. A present common mode choke may be disconnected from the inputs 34, 36.

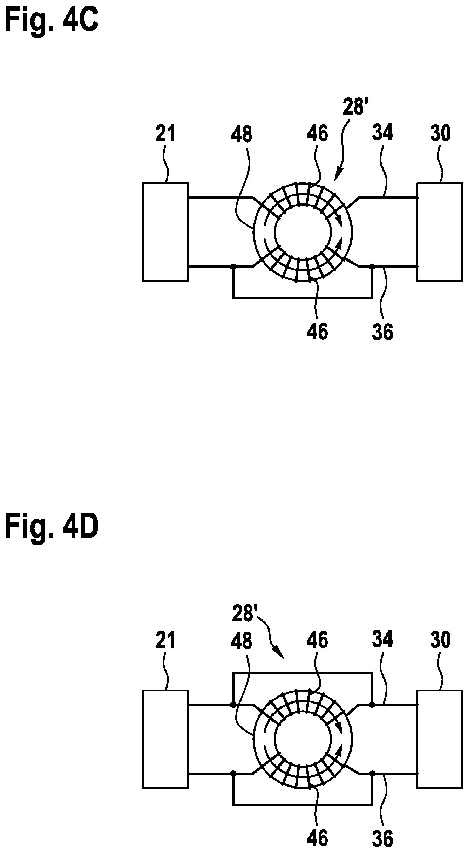

Fig. 4C shows the same arrangement as in Fig. 4A, however with a bypassed common mode choke 28'. However, for a second gate driver 26b', 26d', one of the windings 46 is bypassed, for example with a zero ohm resistor and/or resistance. The remaining winding 46 is not bypassed. As shown in Fig. 4D, it is possible that both and/or all windings 46 are bypassed, for example with a zero ohm resistor and/or resistance. At least one winding 46 of the common mode choke 28', which is interconnected into the positive supply voltage input 34 or the negative supply voltage input 36, may be bypassed.

Analogously, the arrangement of Fig. 3 may be used for a second gate driver 26b', 26d', when one or both of the windings 46 for the supply voltage input 34 and the negative supply voltage input 36 are bypassed.

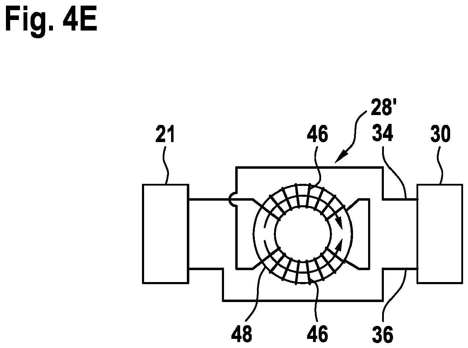

Fig. 4E shows a further example of a bypassed common mode choke 28', wherein two windings 46 of the common mode choke 28' are series connected and are interconnected into the positive supply voltage input 34 or the negative supply voltage input 36. The other one of the positive supply voltage input 34 or the negative supply voltage input 36 is directly connected to the power supply 21.

In general, the common mode choke 28' may be at least partially bypassed for directly connecting at least one of the positive supply voltage input 34 and the negative supply voltage input 36 of a second gate driver 26b', 26d' with the power supply 21.

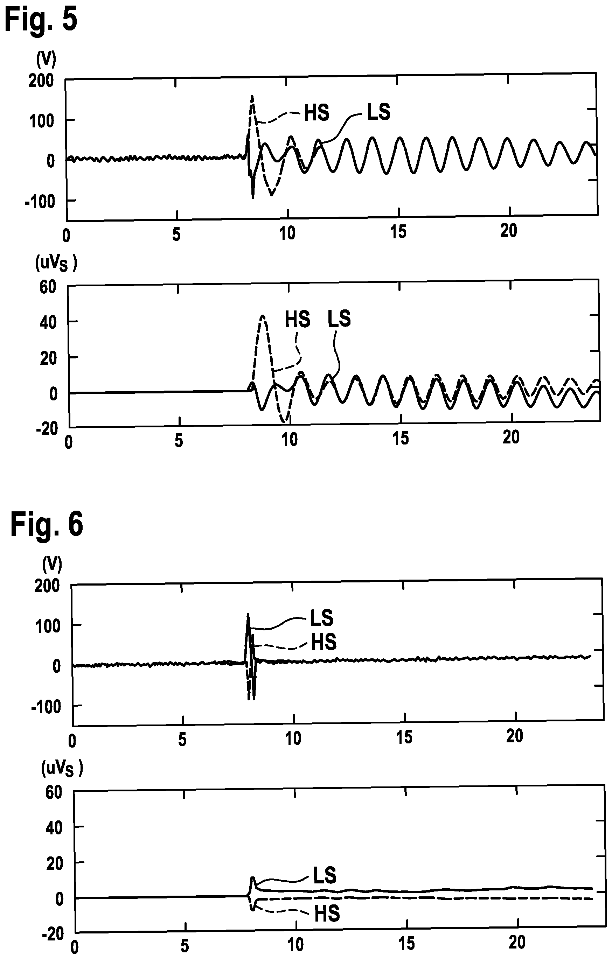

Fig. 5 and 6 show diagrams with measurements of two hard-paralleled Si IGBT modules under continuous operation. Fig. 5 shows measurements for symmetrically arranged common mode chokes 28 such as in Fig. 1. Fig. 6 shows measurements for asymmetrically arranged common mode chokes 28 such as in Fig. 2. Both Fig. 5 and 6 depict the common mode choke voltage and flux utilization for a switching transient. The voltage applied to the symmetrically arranged common mode chokes 28 is a superposition of the voltages generated in the two loops 42, 44, i.e. the difference between the switching transients of the paralleled modules in the module-to-module emitter loop 42 and the voltage division between the common mode chokes 28 and the auxiliary transformer's parasitic stray capacitances in the high side/low side loops 44. In contrast, the asymmetrically arranged common mode choke only takes the voltage from the module-to-module emitter loop 42 as intended. Note that this voltage is seen with double the amplitude in the asymmetric case as only one instead of two chokes 28 are active in the module-to-module emitter loop 42.

It can be observed that a cleaner voltage without oscillation is achievable with the asymmetric common mode choke arrangement. In Fig. 6, it can be observed that the voltage waveform of the asymmetric arrangement is much cleaner and better defined. Only during the voltage transient of the main devices, short spikes are visible due the difference in the switching transients. In contrast, the symmetric common mode choke arrangement additionally see the voltage from the loop 44, resulting not only into a larger but also longer voltage peak due to the choked charging of the auxiliary transformer's stray capacitances. In addition to the peak voltage, a pronounced ringing with a duration of several tens of microseconds can be seen in Fig. 5. This is most likely caused by the slight oscillation in the load after each transient. This oscillation may propagate to the gate driver 26a-26d and may excite the loop 44.

Overall, this ringing may lead to increased losses and may mean that the common mode chokes 28 are in an undefined state at the beginning of the next switching transient.

Additionally, a significantly reduced peak flux can be observed. The lower voltage utilization coming from the module-to-module loop 42 only results in a four times lower peak flux in the asymmetric common mode choke arrangement. In contrast to the symmetric common monde choke arrangement, this peak flux is largely invariant from the chosen inductance value, i.e. will in particular not increase in case of a greater inductance.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: semiconductor unit
- 12a: first half bridge
- 12b: second half bridge
- 14: gate driver circuit
- 16a: first high side semiconductor switch
- 16b: second high side semiconductor switch
- 16c: first low side semiconductor switch
- 16d: second low side semiconductor switch
- 18: DC voltage source
- 20: AC load
- 21: power supply
- 22: power source
- 23: amplifier
- 24a: high side isolating transformer
- 24b: low side isolating transformer
- 26a: first high side gate driver
- 26b: second high side gate driver
- 26c: first low side gate driver
- 26d: second low side gate driver
- 28: common mode choke
- 30: amplifier
- 32: gate resistance
- 34: positive supply voltage input
- 36: negative supply voltage input
- 38: gate signal input
- 40: controller
- 42: current loop
- 44: current loop
- 26b': second high side gate driver
- 26d': second low side gate driver
- 46: winding
- 48: core
- 50: reference potential input
- 52: gate output
- 54: gate resistor
- 56: diode
- 58: gate resistor
- 60: resistor
- 62: reference potential output
- 28': bypassed common mode choke

## Claims

1. A semiconductor unit (10), comprising:
a first semiconductor switch (16a) and a second semiconductor switch (16b), which are connected in parallel;
a gate driver circuit (14);
wherein the gate driver circuit (14) comprises a first gate driver (26a) for the first semiconductor switch (16a) and a second gate driver (26b') for the second semiconductor switch (16b);
wherein each gate driver (26a, 26b') comprises an amplifier (30) with a positive supply voltage input (34), a negative supply voltage input (36) and a gate signal input (38) for receiving a gate signal and for connecting a gate of the respective semiconductor switch (16a, 16b) via a gate output (52) with one of the positive supply voltage input (34) and the negative supply voltage input (36);
wherein the first gate driver (26a) comprises a common mode choke (28) for coupling at least two inputs (34, 36, 38) of the positive supply voltage input (34), the negative supply voltage input (36) and the gate signal input (38) of the first gate driver (26a) via an impedance for a common mode current through the at least two inputs (34, 36, 38);
wherein the at least two inputs (34, 36, 38, 50) of the second gate driver (26b') are coupled with a lesser common mode impedance.

2. The semiconductor unit (10) of claim 1,
wherein the at least two inputs (34, 36, 38, 50) of the second gate driver (26b') are coupled with a common mode impedance that is less than 10% of the common mode impedance of the at least two inputs (34, 36, 38) of the first gate driver (26a).

3. The semiconductor unit (10) of claim 1 or 2,
wherein the common mode choke (28) for the first gate driver (26a) couples at least the positive supply voltage input (34) and the negative supply voltage input (36) via an impedance for a common mode current through at least the positive supply voltage input (34) and the negative supply voltage input (36).

4. The semiconductor unit (10) of one of the preceding claims,
wherein the common mode choke (28) for the first gate driver (26a) couples at least the positive supply voltage input (34), the negative supply voltage input (36) and the gate signal input (38) via an impedance for a common mode current through at least the positive supply voltage input (34), the negative supply voltage input (36) and the gate signal input (38).

5. The semiconductor unit (10) of one of the previous claims,
wherein each gate driver (26a, 26b') comprises a reference potential input (50) connected with a reference potential output (62) connected to a negative input of the respective semiconductor switch (16a, 16b);
wherein the common mode choke (28) for the first gate driver (26a) couples at least the positive supply voltage input (34), the negative supply voltage input (36) and the reference potential input (50) via an impedance for a common mode current through at least the positive supply voltage input (34), the negative supply voltage input (36) and the reference potential input (50).

6. The semiconductor unit (10) of one of the previous claims,
wherein the common mode choke (28, 28') comprises a single core (48) with windings (46) interconnected into the at least two inputs (34, 36, 38, 50) or at least two outputs (52, 60).

7. The semiconductor unit (10) of one of the previous claims,
wherein the second gate driver (26b') comprises a common mode choke (28') interconnected into inputs 34, 36, 38, 50) ;
wherein the common mode choke (28') is at least partially bypassed.

8. The semiconductor unit (10) of claim 7,
wherein at least one winding (46) of the common mode choke (28') of the second gate driver (26b') is bypassed.

9. The semiconductor unit (10) of claim 7 or 8,
wherein two windings (46) of the common mode choke (28') of the second gate driver (26b') are series connected and are interconnected into one of the at least two inputs (34, 36, 38, 50).

10. The semiconductor unit (10) of one of the previous claims,
wherein the gate driver circuit (14) comprises a power supply (21) for supplying the gate drivers (26a, 26b') via the positive supply voltage input (34) and the negative supply voltage input (36).

11. The semiconductor unit (10) of claim 10,
wherein the power supply (21) comprises an isolation transformer (24a) supplying the positive supply voltage input (34) and the negative supply voltage input (36) of the first gate driver (26a) and the second gate driver (26b').

12. The semiconductor unit (10) of claim 10 or 11,
wherein the isolation transformer (24a) is connected via an amplifier (23) with a power source (22).

13. The semiconductor unit (10) of one of the previous claims, comprising:
a first half bridge (12a) and a second half bridge (12b);
wherein the first half bridge (12a) comprises a first high side semiconductor switch (16a) and a first low side semiconductor switch (16c), which are connected in series;
wherein the second half bridge (12b) comprises a second high side semiconductor switch (16b) and a second low side semiconductor switch (16d), which are connected in series;
wherein the high side semiconductor switches (16a, 16b) are connected in parallel;
wherein the low side semiconductor switches (16c, 16d) are connected in parallel;
wherein the gate driver circuit (14) comprises first gate drivers (26a, 26c) for the first semiconductor switches (16a, 16c) of the first half bridge (12a) and second gate drivers (26b', 26d') for the second semiconductor switches (16b, 16d) of the second half bridge (12b);
wherein each of the first gate drivers (26a, 26c) comprises a common mode choke (28) for coupling at least two inputs (34, 36, 38, 50) of the respective first gate driver (26a, 26c) via an impedance for a common mode current through the at least two inputs (34, 36, 38, 50);
wherein the at least two inputs (34, 36, 38, 50) of the second gate drivers (26b') are coupled with a lesser common mode impedance.

14. The semiconductor unit (10) of claim 13,
wherein the gate driver circuit (14) comprises a power supply (21) for supplying the gate drivers (26a, 26b') via the positive supply voltage input (34) and the negative supply voltage input (36);
wherein the power supply (21) comprises a high side isolation transformer (24a) supplying the positive supply voltage input (34) and the negative supply voltage input (36) of the first high side gate driver (26a) and of the second high side gate driver (26b');
wherein the power supply (21) comprises a low side isolation transformer (24b) supplying the positive supply voltage input (34) and the negative supply voltage input (36) of the first low side gate driver (26c) and of the second low side gate driver (26d').

15. The semiconductor unit (10) of claim 15,
wherein the high side isolation transformer (24a) and the low side isolation transformer (24b) are connected via an amplifier (23) with a power source (22).
